# FASCICULE DE BREVET EUROPEEN

(11) **EP 0 494 458 B1**
(45) Date de publication et mention de la délivrance du brevet: **17.11.1994**
(21) Numéro de dépôt: 91122377.4
(22) Date de dépôt: 30.12.1991
(51) Int. Cl.: C03C 10/02, C03C 23/00, C04B 35/00, C04B 35/60, H01L 39/24

(54) **Elément composite pour la connectique en électronique et procédé de fabrication d'un tel élément**
Kompositelement für einen elektronischen Verbinder und Verfahren zur Herstellung eines solchen Elements
Composite element for electric connector and method for the fabrication of such an element

(30) Priorité: 04.01.1991 FR 9100071
(43) Date de publication de la demande: 15.07.1992
(73) Titulaire: ALCATEL ALSTHOM COMPAGNIE GENERALE D'ELECTRICITE, 75382 Paris Cédex 08 (FR)
(72) Inventeur: Belouet, Christian, F-92330 Sceaux (FR); Ribes, Michel, F-34830 Clapiers (FR)
(74) Mandataire: Weinmiller, Jürgen

(56) Documents cités:
- EP-A- 0 285 106
- WORLD PATENTS INDEX (LATEST), accession no. 90-358176, semaine 48, DerwentPublications Ltd, Londres, GB; &JP-A-2 258 699 (KOKUSAI CHODENKO) 19-10-1990
- JAPANESE JOURNAL OF APPLIED PHYSICS, vol. 28, no. 11, novembre 1989, pages2211-2218, Tokyo, JP; S. OTSUBO et al.: "Crystallization induced by laserirradiation in Ba-Y-Cu-O superconducting films prepared by laser ablation"
- EXTENDED ABSTRACTS OF THE 20TH CONFERENCE ON SOLID STATE DEVICES AND MATERIALS,Tokyo, 24-26 août 1988, pages 435-438; Y. YONEZAWA et al.: "Preparation of highTc oxide superconducting films by laser annealing"
- JOURNAL OF NON-CRYSTALLINE SOLIDS, vol. 113, no. 2/3, 4 septembre 1989, pages274-281, Amsterdam, NL; T. KOMATSU et al.: "Superconducting properties ofglass-ceramics in the Bi-Sr-Ca-Cu-O system"
- APPLIED PHYSICS LETTERS, vol. 55, no. 15, 9 octobre 1989, pages 1572-1574, NewYork, US; N.P. BANSAL et al.: "Glass-derived superconducting ceramics with zeroresistance at 107 K in the Bi1.5Pb0.5Sr2Ca2Cu3Ox system"

## Description

La présente invention concerne un élément composite pour la connectique en électronique et un procédé de fabrication d'un tel élément.

La densification des composants électroniques a conduit au concept de connectique à trois dimensions, les pièces étant empilées et interconnectées au moyen de plaques intercalaires qui sont des éléments composites constitués d'une matrice isolante, par exemple en verre, dans laquelle est réalisé un réseau de contacts métalliques débouchant sur les deux faces de l'élément.

A l'heure actuelle on réalise un tel élément en prenant une matrice isolante généralement en verre, en la perçant par une technique de gravure chimique et en remplissant les trous ainsi obtenus par un métal pour définir alors des chemins conducteurs.

La présente invention a pour but de mettre en oeuvre des éléments composites pour la connectique en électronique qui soient de réalisation plus souple que les éléments connus et qui soient plus performants.

La présente invention a pour objet un élément composite pour la connectique en électronique constitué d'un ruban en matériau vitreux incluant des chemins conducteurs, caractérisé par le fait que ledit matériau vitreux a une formulation chimique sensiblement identique à celle d'un oxyde supraconducteur à haute température critique, que lesdits chemins conducteurs sont des zones où ledit matériau se trouve sous forme cristallisée et qu'ils débouchent sur les deux faces principales dudit ruban.

On a ainsi un ruban monolithique autosupporté utilisable pour la connectique en trois dimensions.

A titre d'exemple, ladite formulation chimique est du type Bi₂ Sr₂ Ca Cu₂ O_{z}, Bi₂₋ₓ Pbₓ Sr₂ Ca₂ Cu₃ O_{y}, avec z ∼ 8 et y ∼ 10.

Le matériau vitreux est électriquement isolant tandis que les zones cristallisées sont supraconductrices et, à température ambiante, présentent un caractère métallique.

Typiquement la résistivité du matériau vitreux est de l'ordre de 10⁷ Ω cm à 10⁹ Ω cm et celle des zones cristallisées à la température ordinaire est de l'ordre de 10⁻² Ω cm à 10⁻³ Ω cm à la température ambiante.

On a ainsi un connecteur monolithique avec un circuit conducteur programmé.

A titre d'exemple, un ruban selon l'invention a une épaisseur de l'ordre de quelques dizaines de micromètres, une longueur et une largeur de quelques centimètres.

La présente invention a également pour objet un procédé de fabrication d'un élément composite précédemment défini.

Ainsi, on part de l'élément à l'état vitreux et on le chauffe localement au niveau desdites zones de manière à porter ces dernières à la température de cristallisation.

De préférence, l'ensemble de l'élément est chauffé à une température voisine de la température de transition vitreuse et il n'y a à apporter qu'un complément d'énergie pour amener lesdites zones à l'état cristallisé.

Selon un mode avantageux de mise en oeuvre on utilise pour chauffer lesdites zones un laser à balayage programmé.

La matrice vitreuse environnante, qui est un bon isolant thermique, reste à une température inférieure à la température de transition vitreuse tandis que le faisceau laser porte localement le matériau vitreux à une température proche de la température de cristallisation et opère rapidement cette dernière. Le rôle du faisceau laser est dans ce cas de délimiter au mieux la dimension latérale des zones à cristalliser, soit en surface, soit en profondeur pour un contact débouchant.

Les paramètres de l'écriture laser (longueur d'onde, durée, intensité et fréquence des impulsions, dimensions du spot et vitesse de balayage) sont totalement déterminés par les besoins du circuit et la nature du matériau vitreux.
Les contats en surface requièrent de préférence une irradiation sous faisceau laser focalisé, à courte longueur d'onde, notamment pour l'écriture de lignes micrométriques.
Par contre les contacts débouchants, de diamètre typique supérieur ou égal à 10 µm, sont avantageusement réalisés avec un faisceau laser parallèle.

La réalisation simultanée de contacts en surface et de contacts débouchants dans un même connecteur peut être envisagée si leurs largeurs et leurs diamètres de ligne présentent le même ordre de grandeur, supérieur à 10 µm.

Le procédé selon l'invention permet en outre de retoucher aisément un connecteur par ajout de lignes en surface ou de contacts débouchants.

D'autres caractéristiques et avantages de la présente invention apparaîtront au cours de la description suivante d'un mode de réalisation donné à titre illustratif mais nullement limitatif.

On réalise des contacts de surface en forme de lignes micrométriques sur une matrice vitreuse en Bi_{1,6} Pb_{0,4} Sr₂ Ca₂ Cu₃ O₁₀ dont la température de transition vitreuse est 577 K et dont la température de cristallisation est 724 K.

On met en oeuvre un laser pulsé à yag dopé au néodyme de longueur d'onde de 1,06 µm ou 0,53 µm (dans ce dernier cas le laser est associé à un doubleur de fréquence). La durée de chaque impulsion est de 200 ns.

Pour réaliser des contacts de surface il est avantageux d'utiliser le rayonnement à 0,53 µm. Dans le cas d'une ligne conductrice de largeur voisine de 2 µm, les conditions d'irradiation sont les suivantes :
- vitesse de déplacement du ruban de quelques centimètres par minute,
- fréquence des impulsions de 1000 Hz environ,
- puissance incidente voisine de 1 mwatt.

Pour réaliser des contacts débouchant sur les deux faces du ruban, ce dernier étant en position fixe sous le faisceau laser, il est avantageux d'utiliser le rayonnement à 1,06 µm. Pour un ruban d'épaisseur 50 µm et un contact de diamètre 50 µm, les conditions opératoires sont les suivantes :
- fréquence des impulsions de 1000 Hz environ,
- puissance incidence inférieure ou égale à 80 mwatts,
- durée d'irradiation inférieure ou égale à 1 seconde.

Bien entendu l'invention n'est pas limitée au matériau, ni au laser qui viennent d'être indiqués. On pourra, sans sortir du cadre de l'invention remplacer tout moyen par un moyen équivalent. Ainsi, dans le cas où l'oxyde supraconducteur concerné n'est pas sujet à une perte importante d'oxygène, le faisceau laser peut être remplacé par un faisceau d'électrons.

## Revendications

1. Elément composite pour la connectique en électronique constitué d'un ruban en matériau vitreux incluant des chemins conducteurs, caractérisé par le fait que ledit matériau vitreux a une formulation chimique sensiblement identique à celle d'un oxyde supraconducteur à haute température critique, que lesdits chemins conducteurs sont des zones où ledit matériau se trouve sous forme cristallisée et qu'ils débouchent sur les deux faces principales dudit ruban.

2. Elément composite selon la revendication 1, caractérisé par le fait que ladite formulation chimique est du type Bi₂ Sr₂ Ca Cu₂ O_{z} (avec z ∼ 8) ou Bi₂₋ₓ Pbₓ Sr₂ Ca₂ Cu₃ O_{y} (avec y ∼ 10).

3. Elément composite selon l'une des revendications 1 et 2, caractérisé par le fait que ledit ruban a une épaisseur de l'ordre de quelques dizaines de micromètres.

4. Procédé de fabrication d'un élément composite selon l'une des revendications précédentes, caractérisé par le fait que l'on part dudit élément à l'état vitreux, qu'on le chauffe localement au niveau desdites zones de manière à porter ces dernières à la température de cristallisation du verre.

5. Procédé de fabrication selon la revendication 4, caractérisé par le fait que l'ensemble de l'élément est porté à une température voisine de la température de transition vitreuse, de manière qu'il n'y ait à apporter qu'un complément d'énergie pour amener lesdites zones à l'état cristallisé.

6. Procédé de fabrication selon l'une des revendications 4 et 5, caractérisé par le fait que lesdites zones sont chauffées par faisceau laser.

## Claims

1. A composite component for connection purposes in electronics, the component being constituted by a tape of vitreous material including conducting paths, characterized in that said vitreous material has a chemical formulation substantially identical to that of a superconducting oxide having a high critical temperature, in that said conducting paths are zones where said material is in crystallized form, and in that said paths open out into the two main faces of said tape.

2. A composite component according to claim 1, characterized by the fact that said chemical formulation is of the type Bi₂Sr₂CaCu₂O_{z} (with z ≈ 8) or Bi₂₋ₓPbₓSr₂Ca₂Cu₃O_{y} (with y ≈ 10).

3. A composite component according to claim 1 or 2, characterized by the fact that said tape has a thickness of the order of a few tens of micrometers.

4. A method of manufacturing a composite component according to any preceding claim, the method being characterized by the fact that starting with said component in the vitreous state, it is heated locally at said zones so as to raise said zones to the crystallization temperature of the glass.

5. A manufacturing method according to claim 4, characterized by the fact that the entire component is raised to a temperature close to the vitreous transition temperature so that said zones can be brought to the crystallized state merely by applying additional energy.

6. A manufacturing method according to claim 4 or 5, characterized by the fact that said zones are heated by a laser beam.

## Patentansprüche

1. Verbundelement für Elektronikverbindungen bestehend aus einem Band aus glasartigem Material, das Leitwege enthält, dadurch gekennzeichnet, daß das glasartige Material eine chemische Formel hat, die im wesentlichen der eines supraleitenden Oxids mit hoher kritischer Temperatur gleicht, daß die Leitwege Zonen sind, in denen das Material in kristallisierter Form vorliegt und daß sie auf den beiden Hauptflächen des Bands münden.

2. Verbundelement nach Anspruch 1, dadurch gekennzeichnet, daß die chemische Formel des Materials Bi₂ Sr₂ Ca Cu₂ O_{z} (mit z ≈ 8) oder Bi₂₋ₓ Pbₓ Sr₂ Ca₂ Cu₃ O_{y} (mit y ≈ 10) ist.

3. Verbundelement nach einem der Ansprüche 1 und 2, dadurch gekennzeichnet, daß das Band eine Dicke in der Größenordnung von einigen zehn Mikrometern aufweist.

4. Verfahren zur Herstellung eines Verbundelements nach einem der vorhergehenden Ansprüche, dadurch gekennzeichnet, daß man von dem Element im glasartigen Zustand ausgeht, daß man es lokal in den erwähnten Zonen erhitzt, um diese letzteren auf die Kristallisationstemperatur zu bringen.

5. Herstellungsverfahren nach Anspruch 4, dadurch gekennzeichnet, daß die Gesamtheit des Elements auf eine Temperatur nahe der Temperatur des Glasübergangs gebracht wird, so daß nur eine ergänzende Energiemenge beigebracht werden muß, um die erwähnten Zonen in den kristallisierten Zustand zu bringen.

6. Herstellungsverfahren nach einem der Ansprüche 4 und 5, dadurch gekennzeichnet, daß diese Zonen durch einen Laserstrahl erhitzt werden.
